(19) Europäisches Patentamt
European Patent Office
Office européen des brevets

(11) EP 2 667 508 B1

(12) **EUROPEAN PATENT SPECIFICATION**

(45) Date of publication and mention of the grant of the patent:
**09.12.2015 Bulletin 2015/50**

(51) Int Cl.:
***H03H 17/02*** *(2006.01)* ***G06F 17/15*** *(2006.01)*

(21) Application number: **13168597.6**

(22) Date of filing: **21.05.2013**

(54) **Method and apparatus for efficient frequency-domain implementation of time-varying filters**

Verfahren und Vorrichtung zur effizienten Frequenzdomänenimplementierung von zeitvariablen Filtern

Procédé et appareil de mise en oeuvre efficace dans le domaine fréquentiel de filtres variant dans le temps

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.05.2012 US 201261649811 P**
**20.05.2013 US 201313898428**

(43) Date of publication of application:
**27.11.2013 Bulletin 2013/48**

(73) Proprietor: **STMicroelectronics, Inc.**
**Coppell, TX 75019 (US)**

(72) Inventor: **Vickers, Earl Corban**
**Saratoga, CA California 95070 (US)**

(74) Representative: **Style, Kelda Camilla Karen**
**Page White & Farrer**
**Bedford House**
**John Street**
**London, WC1N 2BF (GB)**

(56) References cited:
**WO-A1-01/18960**

- **MARIN-HURTADO J I ET AL: "Distortions in speech enhancement due to block processing", ACOUSTICS SPEECH AND SIGNAL PROCESSING (ICASSP), 2010 IEEE INTERNATIONAL CONFERENCE ON, IEEE, PISCATAWAY, NJ, USA, 14 March 2010 (2010-03-14), pages 4774-4777, XP031697129, ISBN: 978-1-4244-4295-9**
- **CHRISTELLE YEMDJI ET AL: "A scalable frequency domain-based linear convolution architecture for speech enhancement", DIGITAL SIGNAL PROCESSING (DSP), 2011 17TH INTERNATIONAL CONFERENCE ON, IEEE, 6 July 2011 (2011-07-06), pages 1-6, XP032047952, DOI: 10.1109/ICDSP.2011.6004894 ISBN: 978-1-4577-0273-0**
- **VICKERS ET AL: "Frequency-Domain Implementation of Time-Varying FIR Filters", AES CONVENTION 133; 20121001, AES, 60 EAST 42ND STREET, ROOM 2520 NEW YORK 10165-2520, USA, 25 October 2012 (2012-10-25), XP040574835,**

**EP 2 667 508 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### TECHNICAL FIELD

The present disclosure relates generally to electronic filters, and more specifically to frequency-domain implementation of time-varying filters.

### BACKGROUND

Time-varying finite impulse response (FIR) filters are utilized in a variety of different types of electronic systems, such as in audio systems where audio effects like speech enhancement and channel "upmix" are often implemented using such filters. Upmix is the processing of an audio signal in a given format, such as stereo or mono, to parse that signal and generate audio signals for additional channels like in 5.1 or 7.1 surround sound. FIR filters can be implemented efficiently by the means of "fast convolution," which involves converting an input signal in the time-domain signal to the frequency domain using the fast Fourier transform (FFT), multiplying the frequency spectra of the input signal the FIR spectra, and then performing an inverse-FFT (IFFT) to transform the signal back into the time domain. For real-time implementations with ongoing audio signals, the short-time Fourier transform (STFT) is often used instead of fast convolution, as will be appreciated by those skilled in the art.

The above fast convolution procedure can be used to implement linear convolution so long as the following constraint is observed: $N \geq L + M - 1$ where N is the FFT length, L is the unpadded length of an audio input frame $x_r(n)$, and M is the unpadded length of the FIR filter's impulse response $h_r(n)$, for a frame index r. In many applications, this constraint is easily satisfied using an overlap-add (OLA) STFT method by zero-padding input frames $x_r(n)$ and $h_r(n)$ to FFT length N. In applications such as speech enhancement or upmix, however, where the filter is a time-varying function of the input signal, meeting this constraint may not be practicable. The time-varying FIR filter is realized by modifying the FFT of the zero-padded input frame $x_r(n)$, often using a non-linear function, to yield the desired filter's frequency response $H_r(k)$ (where k is the frequency index). In this situation, even though the zero-padded input frame $x_r(n)$ has only has L non-zero values (e.g., L = N/2), the IFFT of the filter impulse response Hr(k) typically has N non-zero values, violating the constraint $N \geq L + M - 1$ (1). This violation of the constraint results in time-domain aliasing that may cause undesirable audible artifacts in the output of the filter. There is accordingly a need for efficient frequency-domain implementations of time-varying FIR filters so that the filters are fast enough for required applications while introducing minimal audible artifacts in the output of the filter.

### SUMMARY

Embodiments of the present disclosure are directed to efficient frequency-domain implementations of time-varying FIR filters. More specifically, time-varying FIR filters according to one embodiment of the present disclosure exploit the duality of the fast Fourier transform that windowing in the time domain equals convolution in the frequency domain. In one embodiment, convolution of the output of the FIR filter and a desired windowing function is performed in the frequency domain instead of taking the output of the FIR filter in the frequency domain, converting this output the time domain via an IFFT, and then windowing this output in the time domain before again converting back to the frequency domain. In this way, so long as the windowing function has certain characteristics, then the time-varying FIR filter is both computationally efficient and introduces minimal audible artifacts into the output of the filter, as will be described in more detail below. While the embodiments and concepts described herein are discussed in terms of audio signals and systems, these embodiments and concepts may be applicable to other type of signals and systems as well, and thus are not limited to audio signals and systems.

According to an aspect, there is provided a method of filtering a digital electronic signal including a plurality of input frames, the method comprising: windowing the input frames to generate windowed input frames; zero-padding the windowed input frames to generate zero-padded and windowed input frames; performing an FFT on the zero-padded and windowed input frames to generate frequency domain samples of the zero-padded and windowed input frames; filtering the frequency domain samples of the windowed input frame, the operation of filtering including, adjusting frequency domain coefficients of the filtering operation responsive to the frequency domain samples of the input frame; convolving the adjusted frequency domain coefficients with the frequency domain coefficients of a filter truncation window to generate convolved frequency domain coefficients; multiplying the frequency domain samples of the input frame by the convolved frequency domain coefficients to generate filtered input frame samples; performing an inverse FFT on the filtered input frame samples to generate filtered time domain samples; and performing an overlap-add operation on successive filtered time domain samples to generate filtered input frames.

The filter truncation window may comprise a Tukey window.

The Tukey window may be zero-padded.

The Tukey window may includes zero-padding of 11N/16, where 2N equals the length of the FFT.

The Tukey window may include half-Hann transitions of length N/8.

The Tukey window may include a central unity gain segment of length 3N/8.

The filter truncation window may comprise a sparse filter truncation window.

The filter truncation window may comprise a zero-padded Hann window.

The length L of the input frames may equal the length M filtering operation which equals the length N of the FFT.

The filter truncation window may comprise a filter truncation window derived through projections onto convex sets.

The digital electronic signal may comprise an audio signal.

The filtering operation may comprise a time-varying finite impulse response filtering operation.

The filter truncation window may comprise a zero-padded Blackman filter truncation window.

According to another aspect, there is provided a method of filtering a digital electronic signal including a plurality of input frames, the method comprising: windowing the input frames to generate windowed input frames; zero-padding the windowed input frames to generate zero-padded and windowed input frames; performing an FFT on the zero-padded and windowed input frames to generate frequency domain samples of the zero-padded and windowed input frames; adapting frequency domain coefficients of a time-varying FIR filter using the frequency domain samples of the input frames; convolving the adjusted frequency domain coefficients of the time-varying with the frequency domain coefficients of a filter truncation window to generate convolved frequency domain coefficients; multiplying the frequency domain samples of the input frame by the convolved frequency domain coefficients to generate filtered input frame samples; performing an inverse FFT on the filtered input frame samples to generate filtered time domain samples; and performing an overlap-add operation on successive filtered time domain samples to generate filtered input frames.

The filter truncation window may comprise a Tukey window.

The filter truncation window may comprise a zero-padded Blackman filter truncation window.

The filter truncation window may comprise a zero-padded Hann window.

According to an aspect, there is provided an electronic system, comprising: electronic circuitry including, filter circuitry adapted to receive digital input frames generate filtered input frames from the input filter frames, the filter circuitry operable to, window the input frames to generate windowed input frames; zero-pad the windowed input frames to generate zero-padded and windowed input frames; execute an FFT on the zero-padded and windowed input frames to generate frequency domain samples of the zero-padded and windowed input frames; calculate frequency domain coefficients of a time-varying FIR filter using the frequency domain samples of the input frames; convolve the adjusted frequency domain coefficients of the time-varying FIR filter with the frequency domain coefficients of a filter truncation window to generate convolved frequency domain coefficients; multiply the frequency domain samples of the input frame by the convolved frequency domain coefficients to generate filtered input frame samples; execute an inverse FFT on the filtered input frame samples to generate filtered time domain samples; and perform an overlap-add operation on successive filtered time domain samples to generate filtered input frames.

The electronic circuitry may comprise audio circuitry and the digital input frames comprise audio input frames.

The electronic filter circuitry may be operable to perform channel upmix or speech enhancement of the audio input frames.

## BRIEF DESCRIPTION OF THE DRAWINGS

Figure 1 is a functional block diagram illustrating a conventional overlap-add (OLA) method of implementing a time-varying finite impulse response (FIR) filter.

Figure 2 is a functional block diagram illustrating a conventional weighted overlap-add (WOLA) method of implementing a time-varying finite impulse response (FIR) filter.

Figure 3 is a functional block diagram illustrating a prior art frequency extension (FEXT) method of implementing a time-varying finite impulse response (FIR) filter.

Figure 4 is a functional block diagram illustrating a prior art modified frequency extension (M-FEXT) method of implementing a time-varying finite impulse response (FIR) filter.

Figure 5 is a functional block diagram illustrating a prior art filter truncation (TRUNC) method of implementing a time-varying finite impulse response (FIR) filter.

Figure 6 is a functional block diagram illustrating a modified truncation (M-TRUNC) method of implementing a time-varying finite impulse response (FIR) filter according to one embodiment of the present disclosure.

Figure 7 is a graph illustrating a zero-padded Blackman window utilized in the frequency-domain convolution in the method of Figure 6 according to one embodiment of the present disclosure.

Figure 8 is a graph illustrating a zero-padded Tukey analysis window utilized in the frequency-domain convolution in the method of Figure 6 according to another embodiment of the present disclosure.

Figure 9A is a graph showing the impulse responses of the filter Hr in the M-TRUNC method of Figure 6 for the ideal or desired filter, the filter windowed with a target truncation window Wt such as the windows of Figures 7 and 8, and the filter windowed with a sparsified truncation window Ws.

Figure 10 is a functional block diagram of an electronic system including a component that implements the M-TRUNC method according to another embodiment of the present invention.

## DETAILED DESCRIPTION

Embodiments of the present disclosure are directed to efficient frequency-domain implementations of time-varying FIR filters. More specifically, time-varying FIR filters according to one embodiment of the present disclosure exploit the duality of the fast Fourier transform that windowing in the time domain equals convolution in the frequency domain. In one embodiment, convolution of the output of the FIR filter and a desired windowing function is performed in the frequency domain instead of taking the output of the FIR filter in the frequency domain, converting this output to the time domain via an IFFT, and then windowing this output in the time domain before again converting back to the frequency domain. In this way, so long as the windowing function has certain characteristics, then the time-varying FIR filter is both computationally efficient and introduces minimal audible artifacts into the output of the filter, as will be described in more detail below. While the embodiments and concepts described herein are discussed in terms of audio signals and systems, these embodiments and concepts may be applicable to other type of signals and systems as well, and thus are not limited to audio signals and systems.

In the following description, certain details are set forth in conjunction with the described embodiments of the present disclosure to provide a sufficient understanding of these described embodiments. One skilled in the art will appreciate, however, that these and other embodiments may be practiced without these particular details. Furthermore, one skilled in the art will appreciate that the example embodiments described below do not limit the scope of the present disclosure, and various modifications, equivalents, and combinations of the disclosed embodiments and components of such embodiments are within the scope of the present disclosure. Embodiments including fewer than all the components of any of the respective described embodiments may also be within the scope of the disclosure although not expressly described in detail below. Finally, the operation of well-known components and/or processes has not been shown or described in detail below to avoid unnecessarily obscuring the present disclosure.

Before describing embodiments of the present disclosure in more detail, several prior approaches utilized for implementing time-varying FIR filters will first be discussed with reference to Figures 1-5 in order to provide some background that will allow a better understanding of time-varying FIR filters according to embodiments of the present disclosure. Figure 1 is a functional block diagram illustrating a conventional overlap-add (OLA) method 100 of implementing a time-varying finite impulse response (FIR) filter. In this approach, an input frame Xr(n) is windowed at operation 102 to generate an N/2 input frame that is then supplied to an FFT operation 104. The windowing operation 102 frames or windows the input frames Xr(n) and subsequent processing is done on a per-frame basis. This N/2 windowed input frame is zero-padded with N/2 zeros so that an N-length input windowed input frame is supplied to the FFT operation 104. The FFT operation 104 generates N frequency domain samples for each corresponding windowed input frame supplied to the FFT operation. Note the input signal may be an analog signal that then sampled and quantized, typically through an analog-to-digital converter operating at an appropriate sampling rate, to provide a digitized speech signal in the form of digital samples, with a group of successive samples forming a respective input frame Xr.

The N frequency domain samples that form the output of the FFT operation 104 are supplied to the time-varying FIR filter Hr(n) operation 106 and, as previously described above, are utilized to adjust or adapt the characteristics of the filter in response to the supplied frequency domain samples. In this way, the FIR filter Hr operation 106 is a time-varying function of the input frames Xr(n). The output of the FIR filter Hr operation 106 also has a length N and this output of the FIR filter Hr operation is multiplied with the output of the FFT operation 104 in a multiplication operation 108 to thereby filter the output of the FFT operation. The output of the multiplication operation 108 once again has a length N. Recall, multiplication in the frequency domain corresponds to convolution in the time domain, as will be appreciated by those skilled in the art.

The filtered input frame Xr, which corresponds to the output of the multiplication operation 108, is then converted back into the time domain through an inverse FFT operation 110 that once again as a length N corresponding to N filtered samples in the time domain. An overlap-add operation 112 is then performed on successive filtered time domain frames from the inverse FFT operation 110 to thereby generate a filtered input signal FXr that corresponds to a filtered version of the input frames Xr. The details of the operations 102-112 are well understood by those skilled in the art and thus, for the sake of brevity, are not described in great detail herein so as to not unnecessarily obscure the embodiment being described in the present disclosure.

The OLA method 100 can be used to implement perfect linear convolution so long as the constraint $N \geq L + M - 1$ is met as previously mentioned above, where N is the FFT length, L is the unpadded length of input frame $x_r(n)$, and M is the unpadded length of the filter's impulse response $h_r(n)$, for frame index r. In many applications this constraint is easily satisfied by zero-padding input vectors or frames $x_r(n)$ and the filter $h_r(n)$ to the length N of the FFT being performed on the input frames and to which the filter is then applied. Where the filter $H_r(k)$ is a time-varying function of the input signal (i.e. input frames $X_r(n)$) as seen in Figure 1, the filter is obtained by modifying the FFT of the zero-padded input frame, often using a non-linear function, to yield the desired filter's frequency response Hr(k) (where k is the frequency index). In this case, even though the input frame has only L non-zero values (e.g., L = N/2 as show in Figure 1), inverse FFT (IFFT) of Hr(k) typically has N non-zero values, generally violating constraint $N \geq L + M - 1$, which results in time-domain aliasing that may produce audible artifacts.

Figure 2 is a functional block diagram illustrating a conventional weighted overlap-add (WOLA) method 200 of implementing a time-varying finite impulse response (FIR) filter. The method 200 is similar to the method 100 just described with reference to Figure 1, and therefore operations 202-210 and 212 in the method 200 correspond to the operations 102-112 previously described and will not again be described in detail with reference to Figure 2. The WOLA method 200 is identical to the method 100 of Figure 1 except that the method 200 includes a synthesis window Ws operation 211 that is performed on the output of the IFFT 210. This synthesis window Ws operation 211 minimizes the mean squared error of the filtered input signal FXr and reduces "clicks" and "blocking effects" where the input signal is an audio signal. The synthesis window Ws does, however, keep output frames (i.e., frames of the filtered input signal FXr) from "ringing out" as they should which can introduce time aliasing and unwanted modulation artifacts.

Figure 3 is a functional block diagram illustrating a prior art frequency extension (FEXT) method 300 of implementing a time-varying finite impulse response (FIR) filter. Once again, the operations 102-112 previously described with reference to Figure 1 are contained in the method 300 and have been designated 302-312 in the method 300 of Figure 3. The method 300 is similar to the method 100 except that after the FFT operation 304 and FIR filter Hr operation 306 have been performed for a given input frame Xr, the output of the filter Hr and FFT are zero-padded through a zero-padding operation 314. The zero-padding operation 314 includes an inverse FFT operation 316 that converts the output of the FFT operation 304 back into the time domain with the output of this IFFT operation 316 having the length N. The output of the IFFT operation 316 is then zero-padded with N zeroes and another FFT operation 318 performed on this now length 2N frame, with the output of the FFT operation 318 having the length 2N. The output of the FIR filter Hr operation 306 is processed in the same way through an IFFT operation 320 and FFT operation 322 to generate a length 2N output frame from the filter. Each of the outputs from the FFT operation 318 and 322 now have length 2N and are multiplied together in multiplication operation 308 which as seen in Figure 3 now outputs a length 2N filtered output that is then converted back into the time domain through a length 2N IFFT operation 310 followed by a length 2N overlap-add operation 312 to thereby generate a filtered input signal frame FXr also having a length 2N. This approach yields very good results in that the filtered input signal FXr is artifact and distortion free but the additional dual FFT and IFFT operations contained in the zero-padding operation 314 are computationally intensive and thus the method 300 is approximately 1.5 times slower than the method 100.

Figure 4 is a functional block diagram illustrating a prior art modified frequency extension (M-FEXT) method 400 of implementing a time-varying finite impulse response (FIR) filter. The approach in the method 400 exploits the Fourier transform duality that zero-padding in the time domain corresponds to interpolation in the frequency domain. Once again, the operations 102-112 of the method 100 of Figure 1 are contained in the method 300 and have been designated 402-412 in the method 400 of Figure 3. The method 400 includes an interpolation operation 414 that is used in place of the zero-padding operation 314 contained in the method 300 of Figure 3 in an attempt to make the method 400 more efficient. The interpolation operation 414 thus maintains operation in the frequency domain and thereby eliminates the need for the dual IFFT and FFT operations contained in the zero-padding operation 314.

The interpolation operation 414 includes a first interpolation element 416 that interpolates the length N output of the FFT operation 402 to thereby generate a length 2N interpolated frequency-domain frame for the corresponding input frame Xr. The interpolation operation 414 also includes a second interpolation element 418 that interpolates the length N output of the FIR filter Hr operation 406 to thereby generate a length 2N interpolated frequency domain frame for the output of the filter Hr operation. The multiplication operation 408 multiplies these length 2N interpolated outputs together to provide a filtered length 2N output to the IFFT operation 410 which converts this filtered output back into the time domain and supplies the corresponding length 2N value to the overlap-add operation 412 which, in turn, generates filtered input signal frames FXr of length 2N. Ideally the interpolation elements 416 and 418 utilize a "sparse" frequency domain interpolation, meaning that many of the frequency domain coefficients of these interpolations have zero value such that corresponding multiplication operations need not be performed.

Figure 5 is a functional block diagram illustrating a prior art filter truncation (TRUNC) method 500 of implementing a time-varying finite impulse response (FIR) filter. The method 500 includes operations 502-512 that are once again similar to the operations 102-112 previously described with reference to Figure 1. In the approach in the method 500, a windowing operation 514 is utilized. Initially, input frames Xr having length N are windowed by windowing operation 502 and then zero-padded by length N with a length 2N FFT operation 504 and being performed on the zero-padded input to generate 2N frequency domain samples corresponding to the zero-padded input frame. The 2N frequency domain samples from the FFT operation 504 are applied to the FIR filter Hr operation 506 which generates an output of 2N filter frequency domain samples that are then applied to the windowing operation 514.

In the windowing operation 514, the output of the FIR filter Hr operation 506 is converted back into the time domain through a IFFT operation 516, with the output of the IFFT having length 2N and being supplied to a multiplication operation 518 that "windows" these time domain samples using the target window function Wt. The window function Wt selected so that a lot of the components or samples of the window functions are zeros to improve the efficiency of the windowing operation 514. For example, the window function Wt may include one half of its time domain samples having zero values. In this way, the multiplication operation 518 and windowing function Wt reduce or "truncate" the length 2N samples from the FIR filter Hr operation 506 to reduce this number to N samples where one half the samples of the window function are zero. An FFT operation 520 in the windowing operation 514 then converts the length 2N windowed output from the multiplication operation 518 back into the frequency domain where the output of the FFT operation has a length 2N but one half the values are zero to improve the efficiency of the windowing operation 514. The output of the FFT operation 520 is then applied to the multiplication operation 508 and multiplied by the frequency domain samples corresponding to the input frame Xr to thereby output filtered input frame having length 2N. A length 2N IFFT operation 510 then converts the filtered output back into the time domain and an overlap-add operation 512 performs overlap-add operations on successive frames to generate filtered input frames FXr.

Figure 6 is a functional block diagram illustrating a modified truncation (M-TRUNC) method 600 of implementing a time-varying finite impulse response (FIR) filter according to one embodiment of the present disclosure. The method 600 includes operations 502-512 that are once again similar to the operations 102-112 previously described with reference to Figure 1 and thus these operations are not again described in detail with reference to Figure 6. The approach of the method 600 exploits or utilizes another Fourier transform duality, namely that convolution in the frequency domain is equivalent to multiplication in the time domain. Accordingly, with the approach of the method 600 the output of the FIR filter Hr is again "windowed" with a window function or "filter truncation window" Ws having desired characteristics, but this windowing is done in the frequency domain through a convolution operation 614, as will be described in more detail below. Note the term Ws shown in Figure 6 may be referred to as the "filter truncation window" herein merely to simplify the present description although the term Ws is more accurately referred to as the "transform of the filter truncation window w(n)," as will be described in more detail below. In embodiments, to improve efficiency of the method 600 the filter truncation window Ws is a "sparse" window function, meaning that most of the frequency domain samples of the window function have zero values, as will also be described in more detail below.

Initially, input frames Xr having length L=5N/8 are windowed by windowing operation 602 to generate windowed input frames, where an FFT of length 2N is performed on the input frames. The input frames Xr having length L=5N/8 are then zero-padded by length 11N/8 (i.e., so that (5N/8 + 11N/8) = 2N) such that a length 2N zero-padded and windowed frame is supplied to FFT operation 604. The FFT operation 604 generates 2N frequency domain samples for the zero-padded and windowed input frame and these samples are supplied as one input to a multiplication operation 608. The 2N frequency domain samples generated by the FFT operation 604 are also provided to the FIR filter Hr operation 606. The FIR filter Hr operation 606 adjusts the 2N frequency domain or spectral coefficients of the FIR filter to generate adjusted frequency domain coefficients that are then output and applied to the convolution operation 614.

The convolution operation 614 includes a convolution element 616 that performs convolution of or convolves the 2N adjusted frequency domain coefficients output from the FIR filter Hr operation 606 with the frequency domain or spectral coefficients of the filter truncation window Ws. The convolution element 616 thus convolves the 2N frequency domain coefficients from the FIR filter operation 606 and frequency domain coefficients of the sparse filter truncation window Ws. As already mentioned, this convolution in the frequency domain is equivalent to multiplication in the time domain, allowing the desired windowing function to be performed in the frequency domain without the need to convert the output of the FIR filter Hr to the time domain. This results in an improved efficiency of the method 600 so long as the spectral coefficients of the filter truncation window Ws are properly selected, meaning the number of multiplications performed by the convolution element 616 must be controlled or inefficiency will result, as will now be described in more detail. The output of the multiplication operation 608 is filtered input frame samples of length 2N and is supplied to the IFFT 610, which, in turn, converts these filtered input frame samples into 2N filtered time domain samples for filtered time domain frames. The 2N filtered time domain samples are applied to the overlap-add operation 612, which performs overlap-add operations on successive 2N filtered time dome samples to generate the filtered input frames FXr that are generated by the method 600.

The (scaled) circular convolution on the spectral coefficients Ws is defined as follows:

$$\hat{H}(k) = \frac{W(k)\#\ H(k)}{2N} = \frac{1}{2N}\sum_{m=0}^{2N-1} W(m)H\left[((k-m))_{2N}\right], \quad 0 \le k \le 2N-1, \qquad (1)$$

where W(k) is the (sparse) transform of truncation window w(n); H(k) is the transform of the desired filter; $((k\text{-}m))_{2N}$ denotes (k-m) modulo 2N, and $\hat{H}(k)$ is the transform of the truncated (windowed) filter. As mentioned above, the term Ws shown in Figure 6 is technically the Fourier transform or frequency domain representation of the filter truncation window w(n), although the term Ws may be referred to herein as the filter truncation window.

If the filter truncation window Ws is sparse, the computations required by the convolution element 616 are significantly reduced since only the non-zero spectral coefficients of the window Ws need multiplied. Again, the filter truncation window Ws is "sparse" when most of its spectral coefficients have zero values. By windowing the time-varying filter Hr using sparse convolution via element 616 in the frequency domain, the method 600 minimizes the STFT time aliasing without the expense of repeated transforms to and from the time domain. If the transform of the filter truncation window Ws has too many non-zero coefficients, the cost of performing the circular convolution through element 616 may exceed the cost of transforming to and from the time domain to do the windowing, thus negating the advantage of staying in the frequency domain.

Embodiments of the desired truncation window w(n), and the corresponding transform Ws of this window, will now be described in more detail. The window w(n) should have long zero-valued tail(s) in the time domain to prevent time aliasing, and its transform Ws should have a large number of zero-valued coefficients (i.e., be "sparse") to enable efficient convolution. The frequency response of the window w(n) should have a narrow main lobe (implying a wide window in the time domain) and low side lobes; but for greater efficiency, the truncation window should be narrow in the time domain, to allow using a wide analysis window for the input signal and therefore a large hop size, where hop size defines overlap between adjacent windows. These properties tend to conflict with each other so compromise is needed and several possible embodiments of the filter truncation window will now be described in more detail.

In one embodiment of the method 600, a zero-padded Hann window with a non-zero portion of length M > N is utilized for the filter truncation window w(n). The Hann window and its first derivative are continuous, and its transform has only three non-zero (real) values, as will be appreciated by those skilled in the art. These properties suggest that a filter truncation window w(n) derived from the Hann window may have a relatively sparse transform.

In another embodiment, somewhat better side lobe properties may be obtained, at the expense of the main lobe width, by using a zero-padded Blackman window. In one embodiment, for a periodic Blackman window wb of length 11N/8:

$$w_b(t) = 0.42 - 0.5\cos(2\pi t) + 0.08\cos(4\pi t),\quad \text{where } t = \frac{8m}{11N},\ \text{and}\quad 0 \le m < \frac{11N}{8}, \tag{2}$$

a suitable target window wt would be:

$$w_t(n) = \begin{cases} 0, & 0 \le n < \frac{5N}{16} \\ w_b\left(n - \frac{5N}{16}\right) & \frac{5N}{16} \le n < \frac{27N}{16}, \\ 0, & \frac{27N}{16} \le n < 2N \end{cases} \tag{3}$$

An example of such a Blackman window wb is illustrated in Figure 7, which is a graph illustrating such a zero-padded Blackman window that is utilized for the filter truncation window w(n) (transform of this window wb corresponds to Ws in Figure 6). Figure 7 shows samples on the horizontal axis and amplitude of samples on the vertical axis, with N=1024 being the length of the FFT being used in this example embodiment.

With this approach, all the Fourier coefficients (i.e. the coefficient of the transform of the filter truncation window) are real, due to the time-domain symmetry, and they roll off quite rapidly. In one embodiment, all but p=9 Fourier coefficients are set equal to zero, as see in Equation (4) below:

$$W_s(k) = \begin{cases} 591.36, & k = 0 \\ -464.7552, & k = 1 \\ 214.7436, & k = 2 \\ -46.9141, & k = 3 \\ 1.5712, & k = 4 \\ 1.5712, & k = 2044 \\ -46.9141, & k = 2045 \\ 214.7436, & k = 2046 \\ -464.7552, & k = 2047 \\ 0, & else \end{cases}, \tag{4}$$

The corresponding "sparsified" truncation window ws is a very close approximation of target window wt, as shown in Figure 7, which shows both the target filter truncation window wt and the sparsified filter truncation window ws. As seen in Figure 7, the sparsified truncation window ws is a very good approximation of the target window wt. Such a sparsified filter truncation window ws will result in an efficient (i.e. computationally simple or inexpensive convolution via element 616 in the frequency domain). In other embodiments, additional speed-up may be obtained due to the Hermitian symmetry of the transforms of real signals. Other embodiments utilize other target windows wt that are suitable defined depending on the desired tradeoff between main lobe width, side lobe attenuation and efficiency. The filter truncation window wt may also be derived through projections onto convex sets.

Figure 8 is a graph illustrating a zero-padded Tukey analysis window utilized in the frequency-domain convolution in the method 600 of Figure 6 according to another embodiment of the present disclosure. The figures shows a complete Tukey analysis window corresponding to the central unity gain segment, transitions on both ends of this central unity gain segment, and zero-padding on both ends outside the transitions. The figure also shows portions of adjacent Tukey windows. The hop size can be significantly increased (thus reducing the cost) by instead using a zero-padded Tukey analysis window as seen in Figure 8. This example has zero-padding of 11N/16 samples on each end, half-Hann transitions of length N/8, and a central, unity-gain segment of length 3N/8. As before, the non-zero portion has a length L = 5N/8, satisfying the time aliasing constraint. The advantage is that the cross-fade points are now closer to the edges of the window, allowing a hop size of N/2 compared to 5N/16 for the Hann window; this increases the efficiency by a factor of 1.6 for this example. To some extent, efficiency can be traded off against smoother transitions by adjusting the width of the half-Hann segments. By adjusting this parameter, the Tukey window can transition all the way from a Hann window to a rectangle.

Given the example target filter truncation window wt with unpadded length M = 11N/8, a suitable unpadded analysis window length would be L = 5N/8; the sum L+M equals the current FFT length 2N, thus satisfying the constraint to avoid time-domain aliasing. In practice, some very low level aliasing will occur due to the fact that the tails of the sparsified truncation window ws are not exactly zero, due to the modified spectral coefficients. If, e.g., a Hann window is used for analysis window w, the analysis window length L implies a maximum hop size (delay between successive overlapping frames) of 5N/16.

The filter truncation window should minimize the blurring of adjacent frequency bins, which implies that the truncation window's spectrum should have a narrow main lobe, which implies a wide truncation window in the time domain, which necessitates a narrow analysis window (to avoid aliasing), which implies a small hop size, which, in turn, increases the computational cost.

Figure 9A is a graph showing the impulse responses of the filter Hr in the M-TRUNC method 600 of Figure 6 for the ideal or desired filter, the filter windowed with a target truncation window wt and sparsified window ws such as the windows of Figures 7 and 8, and the filter frequency response transform sparsified truncation window Ws. In the example of Figure 9A, most of the filter energy is centered around the middle of the time response, as is typical of causal filters for loudspeaker compensation or upmix. In Figure 9B, the dashed and solid curves show the filter as truncated in the M-TRUNC method. The filter h (i.e., transform Hr in Figure 6) windowed with the target truncation window wt is shown in dashed and the filter h windowed with the sparsified truncation window ws (using p=9 non-zero transform coefficients) is shown in solid. Note that the dashed and solid curves are very similar, suggesting that little error results from using sparsified truncation window ws instead of the target truncation window wt. In Figure 9C some frequency response error is seen at low frequencies, primarily below 200 Hz, from using either of the truncated filters h. In many applications such error could be acceptable, such as where speakers in a high-definition television are being driven low frequency response of such speakers is not important.

Figure 10 is a functional block diagram of an electronic system 1000 including electronic circuitry 1002 that includes M-TRUNC filter circuitry 1004 for implementing the method 600 of Figure 6. The circuitry 1004 can be hardware, digital or analog circuitry or a combination of both, it can be software, or it can be a combination of both hardware and software. The electronic circuitry 1002 can be any of a variety of different types of circuitry to perform the desired function of the system 1000, such as high-definition television circuitry, surround sound system circuitry, computer circuitry, and so on. In addition, the electronic system 1000 may include one or more input devices 1006, such as a remote control, interface panel in the form of buttons, keyboard, mouse, and so on coupled to the electronic circuitry 1002 to allow an operator to interface with the electronic system. The electronic system 1000 can also include one or more output devices 1008 coupled to the electronic circuitry 1002, with such output devices being, for example, audio equipment like a surround sound system, video displays, and so on. One or more data storage devices 1010 may also be coupled to the electronic circuitry 1002 to store data or retrieve data from external storage media (not shown). Examples of typical storage devices 1010 include video disks like compact disk read-only (CD-ROMs) and compact disk read-write (CD-RW) memories, digital video disks (DVDs), FLASH memory devices, solid state drives, magnetic disk drives, and so on.

In one embodiment, a method of filtering a digital electronic signal including a plurality of input frames includes the operations of windowing the input frames to generate windowed input frames, zero-padding the windowed input frames to generate zero-padded and windowed input frames, performing an FFT on the zero-padded and windowed input frames to generate frequency domain samples of the zero-padded and windowed input frames, filtering the frequency domain samples of the windowed input frame, the operation of filtering including, adjusting frequency domain coefficients of the filtering operation responsive to the frequency domain samples of the input frame and convolving the adjusted frequency domain coefficients with the frequency domain coefficients of a filter truncation window to generate convolved frequency domain coefficients. The method includes multiplying the frequency domain samples of the input frame by the convolved frequency domain coefficients to generate filtered input frame samples, performing an inverse FFT on the filtered input frame samples to generate filtered time domain samples and performing an overlap-add operation on successive filtered time domain samples to generate filtered input frames.

In another embodiment, a method of filtering a digital electronic signal including a plurality of input frames includes windowing the input frames to generate windowed input frames, zero-padding the windowed input frames to generate zero-padded and windowed input frames, performing an FFT on the zero-padded and windowed input frames to generate frequency domain samples of the zero-padded and windowed input frames, adapting frequency domain coefficients of a time-varying FIR filter using the frequency domain samples of the input frames, convolving the adjusted frequency domain coefficients of the time-varying with the frequency domain coefficients of a filter truncation window to generate convolved frequency domain coefficients, multiplying the frequency domain samples of the input frame by the convolved frequency domain coefficients to generate filtered input frame samples, performing an inverse FFT on the filtered input frame samples to generate filtered time domain samples, and performing an overlap-add operation on successive filtered time domain samples to generate filtered input frames.

In a further embodiment, an electronic system includes electronic circuitry including filter circuitry adapted to receive digital input frames generate filtered input frames from the input filter frames. The filter circuitry is operable to window the input frames to generate windowed input frames, zero-pad the windowed input frames to generate zero-padded and windowed input frames, execute an FFT on the zero-padded and windowed input frames to generate frequency domain samples of the zero-padded and windowed input frames, calculate frequency domain coefficients of a time-varying FIR filter using the frequency domain samples of the input frames, convolve the adjusted frequency domain coefficients of the time-varying FIR filter with the frequency domain coefficients of a filter truncation window to generate convolved frequency domain coefficients, multiply the frequency domain samples of the input frame by the convolved frequency domain coefficients to generate filtered input frame samples, execute an inverse FFT on the filtered input frame samples to generate filtered time domain samples and perform an overlap-add operation on successive filtered time domain samples to generate filtered input frames.

One skilled in the art will understand that even though various embodiments and advantages of these embodiments have been set forth in the foregoing description, the above disclosure is illustrative only, and changes may be made in detail, and yet remain within the broad principles of the present disclosure. Moreover, the functions performed by various components described above may be implemented through circuitry or software, or a combination of both, other than as disclosed for the various embodiments described above. Moreover, the described functions of the various components may be combined and performed by fewer elements or may be further divided and performed by more elements, depending upon design considerations for the device or system being implemented, as will appreciated by those skilled in the art. Therefore, the present disclosure is to be limited only by the appended claims.

## Claims

1. A method of filtering a digital electronic signal including a plurality of input frames, the method comprising:

   windowing the input frames to generate windowed input frames;
   zero-padding the windowed input frames to generate zero-padded and windowed input frames;
   performing an FFT on the zero-padded and windowed input frames to generate frequency domain samples of the zero-padded and windowed input frames;
   adjusting frequency domain coefficients using the frequency domain samples of the input frame;
   convolving the adjusted frequency domain coefficients with the frequency domain coefficients of a filter truncation window to generate convolved frequency domain coefficients;
   multiplying the frequency domain samples of the input frame by the convolved frequency domain coefficients to generate filtered input frame samples;
   performing an inverse FFT on the filtered input frame samples to generate filtered time domain samples; and
   performing an overlap-add operation on successive filtered time domain samples to generate filtered input frames.

2. A method as claimed in claim 1, comprising filtering the frequency domain samples of the windowed input frame, wherein the operation of filtering includes the adjusting, said adjusting comprising adjusting the frequency domain coefficients of the filtering operation using the frequency domain samples of the input frame and the convolving.

3. The method of claim 1 or 2, wherein the filter truncation window comprises a Tukey window; a sparse filter truncation window; a zero-padded Hann window; a zero-padded Blackman filter truncation window.

4. The method of claim 3, wherein the Tukey window is zero-padded.

5. The method of claim 3 or 4, wherein the Tukey window includes zero-padding of 11N/16, where 2N equals the length of the FFT.

6. The method of any of claims 3 to 5, wherein the Tukey window includes half-Hann transitions of length N/8.

7. The method of any of claims 3 to 6, wherein the Tukey window includes a central unity gain segment of length 3N/8.

8. The method of claim 3 or any claim appended thereto, wherein the length of the input frames equals the length of filtering operation which equals the length of the FFT.

9. The method of any preceding claim, wherein the filter truncation window comprises a filter truncation window derived through projections onto convex sets.

10. The method of any preceding claim, wherein the digital electronic signal comprises an audio signal.

11. The method of any preceding claim, wherein the filtering operation comprises a time-varying finite impulse response filtering operation.

12. A method as claimed in claim 11, wherein said adjusting comprises adjusting the frequency domain coefficients of a time-varying FIR filter using the frequency domain samples of the input frame.

13. An electronic system, comprising:

electronic circuitry including,
filter circuitry adapted to receive digital input frames generate filtered input frames from the input filter frames, the filter circuitry operable to, window the input frames to generate windowed input frames;
zero-pad the windowed input frames to generate zero-padded and windowed input frames;
execute an FFT on the zero-padded and windowed input frames to generate frequency domain samples of the zero-padded and windowed input frames;
calculate frequency domain coefficients of a time-varying FIR filter using the frequency domain samples of the input frames;
convolve the adjusted frequency domain coefficients of the time-varying FIR filter with the frequency domain coefficients of a filter truncation window to generate convolved frequency domain coefficients;
multiply the frequency domain samples of the input frame by the convolved frequency domain coefficients to generate filtered input frame samples;
execute an inverse FFT on the filtered input frame samples to generate filtered time domain samples; and
perform an overlap-add operation on successive filtered time domain samples to generate filtered input frames.

14. The electronic system of claim 13, wherein the electronic circuitry comprises audio circuitry and the digital input frames comprise audio input frames.

15. The electronic system of claim 13 or 14, wherein the electronic filter circuitry is operable to perform channel upmix or speech enhancement of the audio input frames.

## Patentansprüche

1. Verfahren zum Filtern eines digitalen elektronischen Signals, einschließlich einer Vielzahl von Eingangsframes, wobei das Verfahren Folgendes beinhaltet:

Fenstern der Eingangsframes, um gefensterte Eingangsframes zu generieren;
Auffüllen mit Nullen der gefensterten Eingangsframes, um mit Nullen aufgefüllte und gefensterte Eingangsframes zu generieren;
Durchführen einer FFT an den mit Nullen aufgefüllten und gefensterten Eingangsframes, um Frequenzraumabtastwerte der mit Nullen aufgefüllten und gefensterten Eingangsframes zu generieren;
Anpassen der Frequenzraumkoeffizienten unter Verwendung der Frequenzraumabtastwerte des Eingangsframes;
Falten der angepassten Frequenzraumkoeffizienten mit den Frequenzraumkoeffizienten eines Filtertrunkierungsfensters, um gefaltete Frequenzraumkoeffizienten zu generieren;
Multiplizieren der Frequenzraumabtastwerte des Eingangsframes mit den gefalteten Frequenzraumkoeffizienten, um gefilterte Eingangsframeabtastwerte zu generieren;
Durchführen einer inversen FFT an den gefilterten Eingangsframeabtastwerten, um gefilterte Zeitraumabtastwerte zu generieren; und
Durchführen einer Overlap-Add-Operation an sukzessiven gefilterten Zeitraumabtastwerten, um gefilterte Eingangsframes zu generieren.

**2.** Verfahren gemäß Anspruch 1, das das Filtern der Frequenzraumabtastwerte des gefensterten Eingangsframes beinhaltet, wobei die Operation des Filterns das Anpassen einschließt, wobei das Anpassen das Anpassen der Frequenzraumkoeffizienten der Filteroperation unter Verwendung der Frequenzraumabtastwerte des Eingangsframes und das Falten beinhaltet.

**3.** Verfahren gemäß Anspruch 1 oder 2, wobei das Filtertrunkierungsfenster ein Tukey-Fenster; ein Sparse-Filtertrunkierungsfenster; ein mit Nullen aufgefülltes Hann-Fenster; ein mit Nullen aufgefülltes Blackman-Filtertrunkierungsfenster beinhaltet.

**4.** Verfahren gemäß Anspruch 3, wobei das Tukey-Fenster mit Nullen aufgefüllt ist.

**5.** Verfahren gemäß Anspruch 3 oder 4, wobei das Tukey-Fenster Auffüllen mit Nullen von 11N/16 einschließt, wobei 2N der Länge der FFT gleicht.

**6.** Verfahren gemäß Anspruch 3 bis 5, wobei das Tukey-Fenster Halb-Hann-Übergänge von Länge N/8 einschließt.

**7.** Verfahren gemäß Anspruch 3 bis 6, wobei das Tukey-Fenster ein zentrales Einsverstärkungssegment von Länge 3N/8 einschließt.

**8.** Verfahren gemäß Anspruch 3 oder einem daran anhängenden Anspruch, wobei die Länge der Eingangsframes der Länge der Filteroperation gleicht, die der Länge der FFT gleicht.

**9.** Verfahren gemäß einem vorhergehenden Anspruch, wobei das Filtertrunkierungsfenster ein Filtertrunkierungsfenster beinhaltet, das durch Projektionen auf konvexen Sätzen abgeleitet wurde.

**10.** Verfahren gemäß einem vorhergehenden Anspruch, wobei das digitale elektronische Signal ein Audiosignal beinhaltet.

**11.** Verfahren gemäß einem vorhergehenden Anspruch, wobei die Filteroperation eine zeitvariable Filteroperation mit endlicher Impulsantwort (Finite Impulse Response, FIR) beinhaltet.

**12.** Verfahren gemäß Anspruch 11, wobei das Anpassen das Anpassen der Frequenzraumkoeffizienten eines zeitvariablen FIR-Filters unter Verwendung der Frequenzraumabtastwerte des Eingangsframes beinhaltet.

**13.** Elektroniksystem, das Folgendes beinhaltet:

Elektronikschaltkreise, einschließlich Filterschaltkreise, die angepasst sind, um digitale Eingangsframes zu empfangen gefilterte Eingangsframes von den Eingangsfilterframes zu generieren, wobei die Filterschaltkreise betriebsfähig sind, um

die Eingangsframes zu fenstern, um gefensterte Eingangsframes zu generieren;

die gefensterten Eingangsframes mit Nullen aufzufüllen, um mit Nullen aufgefüllte und gefensterte Eingangsframes zu generieren;

um eine FFT an den mit Nullen aufgefüllten und gefensterten Eingangsframes auszuführen, um Frequenzraumabtastwerte der mit Nullen aufgefüllten und gefensterten Eingangsframes zu generieren;

Frequenzraumkoeffizienten eines zeitvariablen FIR-Filters unter Verwendung der Frequenzraumabtastwerte des Eingangsframes zu berechnen;

die angepassten Frequenzraumkoeffizienten des zeitvariablen FIR-Filters mit den Frequenzraumkoeffizienten eines Filtertrunkierungsfensters zu falten, um gefaltete Frequenzraumkoeffizienten zu generieren;

die Frequenzraumabtastwerte des Eingangsframes mit den gefalteten Frequenzraumkoeffizienten zu multiplizieren, um gefilterte Eingangsframeabtastwerte zu generieren;

eine inverse FFT an den gefilterten Eingangsframeabtastwerten auszuführen, um gefilterte Zeitraumabtastwerte zu generieren; und

eine Overlap-Add-Operation an sukzessiven gefilterten Zeitraumabtastwerten durchzuführen , um gefilterte Eingangsframes zu generieren.

**14.** Elektroniksystem gemäß Anspruch 13, wobei die Elektronikschaltkreise Audioschaltkreise beinhalten und die digitalen Eingangsframes Audioeingangsframes beinhalten.

**15.** Elektroniksystem gemäß Anspruch 13 oder 14, wobei die Elektronikfilterschaltkreise betriebsfähig sind, um Kanal-Upmix oder Sprachverbesserung der Audioeingangsframes durchzuführen.

**Revendications**

**1.** Procédé de filtrage d'un signal électronique numérique qui comprend une pluralité de trames d'entrée, le procédé consistant:

à fenêtrer les trames d'entrée en vue de produire des trames d'entrée fenêtrées;

à remplir de zéros les trames d'entrée fenêtrées en vue de produire des trames d'entrée remplies de zéros et fenêtrées;

à effectuer une transformée de Fourier rapide (TFR) sur les trames d'entrée remplies de zéros et fenêtrées en vue de produire des échantillons dans le domaine fréquentiel des trames d'entrée remplies de zéros et fenêtrées;
à ajuster les coefficients dans le domaine fréquentiel au moyen des échantillons dans le domaine fréquentiel des trames d'entrée;
à effectuer la convolution des coefficients ajustés dans le domaine fréquentiel avec les coefficients dans le domaine fréquentiel d'une fenêtre de troncature du filtre en vue de produire des coefficients dans le domaine fréquentiel qui ont fait l'objet de convolution;
à multiplier les échantillons dans le domaine fréquentiel des trames d'entrée par les coefficients dans le domaine fréquentiel qui ont fait l'objet de convolution en vue de produire des échantillons filtrés des trames d'entrée;
à effectuer une transformée de Fourier rapide inverse sur les échantillons filtrés des trames d'entrée en vue de produire des échantillons filtrés dans le domaine temporel; et
à effectuer une opération de chevauchement-ajout sur des échantillons successifs et filtrés dans le domaine temporel en vue de produire des trames d'entrée filtrées.

2. Procédé selon la revendication 1, consistant à filtrer les échantillons dans le domaine fréquentiel de la trame d'entrée fenêtrée, **caractérisé en ce que** l'opération de filtrage consiste à procéder entre autres à l'ajustement, cet ajustement consistant à ajuster les coefficients dans le domaine fréquentiel de l'opération de filtrage au moyen des échantillons de la trame d'entrée dans le domaine fréquentiel et de la convolution.

3. Procédé selon la revendication 1 ou 2, **caractérisé en ce que** la fenêtre de troncature du filtre est une fenêtre de Tukey; une fenêtre de troncature de filtre épars; une fenêtre de Hann remplie de zéros; une fenêtre de troncature de filtre Blackman remplie de zéros.

4. Procédé selon la revendication 3, **caractérisé en ce que** la fenêtre de Tukey est remplie de zéros.

5. Procédé selon la revendication 3 ou 4, **caractérisé en ce que** la fenêtre de Tukey comprend le remplissage de zéros de 11N/16, où 2N est égal à la longueur de la transformée de Fourier rapide.

6. Procédé selon l'une quelconque des revendications 3 à 5, **caractérisé en ce que** la fenêtre de Tukey comprend des demi-transitions de Hann de longueur égale à N/8.

7. Procédé selon l'une quelconque des revendications 3 à 6, **caractérisé en ce que** la fenêtre de Tukey comprend un segment central de gain unitaire et de longueur égale à 3N/8.

8. Procédé selon la revendication 3 ou toute revendication qui y est annexée, **caractérisé en ce que** la longueur des trames d'entrée est égale à la longueur de l'opération de filtrage qui est égale à la longueur de la transformée de Fourier rapide.

9. Procédé selon l'une quelconque des revendications précédentes, **caractérisé en ce que** la fenêtre de troncature du filtre est une fenêtre de troncature du filtre obtenue par des projections sur des ensembles convexes.

10. Procédé selon l'une quelconque des revendications précédentes, **caractérisé en ce que** le signal électronique numérique comprend un signal audio.

11. Procédé selon l'une quelconque des revendications précédentes, **caractérisé en ce que** l'opération de filtrage comporte une opération de filtrage de la réponse finie aux impulsions variant dans le temps.

12. Procédé selon la revendication 11, **caractérisé en ce que** l'ajustement en question consiste à ajuster les coefficients dans le domaine fréquentiel d'un filtre à réponse impulsionnelle finie (RIF) variant dans le temps au moyen des échantillons des trames d'entrée dans le domaine fréquentiel.

13. Système électronique comportant:

des circuits électroniques qui comprennent des circuits de filtrage adaptés de manière à recevoir des trames d'entrée numériques en vue de produire des trames d'entrée filtrées à partir des trames de filtrage d'entrée, les circuits de filtrage étant utilisés pour:

fenêtrer les trames d'entrée en vue de produire des trames d'entrée fenêtrées;
remplir de zéros les trames d'entrée fenêtrées en vue de produire des trames d'entrée remplies de zéros et fenêtrées;
effectuer une transformée de Fourier rapide (TFR) sur les trames d'entrée remplies de zéros et fenêtrées en vue de produire des échantillons dans le domaine fréquentiel des trames d'entrée remplies de zéros et fenêtrées;
calculer les coefficients dans le domaine fréquentiel d'un filtre à réponse impulsionnelle finie (RIF) variant dans le temps au moyen des échantillons dans le domaine fréquentiel des trames d'entrée;

à effectuer la convolution des coefficients ajustés dans le domaine fréquentiel du filtre RIF avec les coefficients dans le domaine fréquentiel d'une fenêtre de troncature du filtre en vue de produire des coefficients dans le domaine fréquentiel qui ont fait l'objet de convolution;

à multiplier les échantillons dans le domaine fréquentiel des trames d'entrée par les coefficients dans le domaine fréquentiel qui ont fait l'objet de convolution en vue de produire des échantillons filtrés des trames d'entrée;

à effectuer une transformée de Fourier rapide inverse sur les échantillons filtrés des trames d'entrée en vue de produire des échantillons filtrés dans le domaine temporel; et

à effectuer une opération de chevauchement-ajout sur des échantillons successifs et filtrés dans le domaine temporel en vue de produire des trames d'entrée filtrées.

**14.** Système électronique selon la revendication 13, **caractérisé en ce que** les circuits électroniques comprennent des circuits audio et **en ce que** les trames d'entrée numériques comprennent des trames d'entrée audio.

**15.** Système électronique selon la revendication 13 ou 14, **caractérisé en ce que** les circuits électroniques sont utilisés pour effectuer le mélange élévateur des canaux ou pour améliorer la qualité acoustique des trames d'entrée audio.

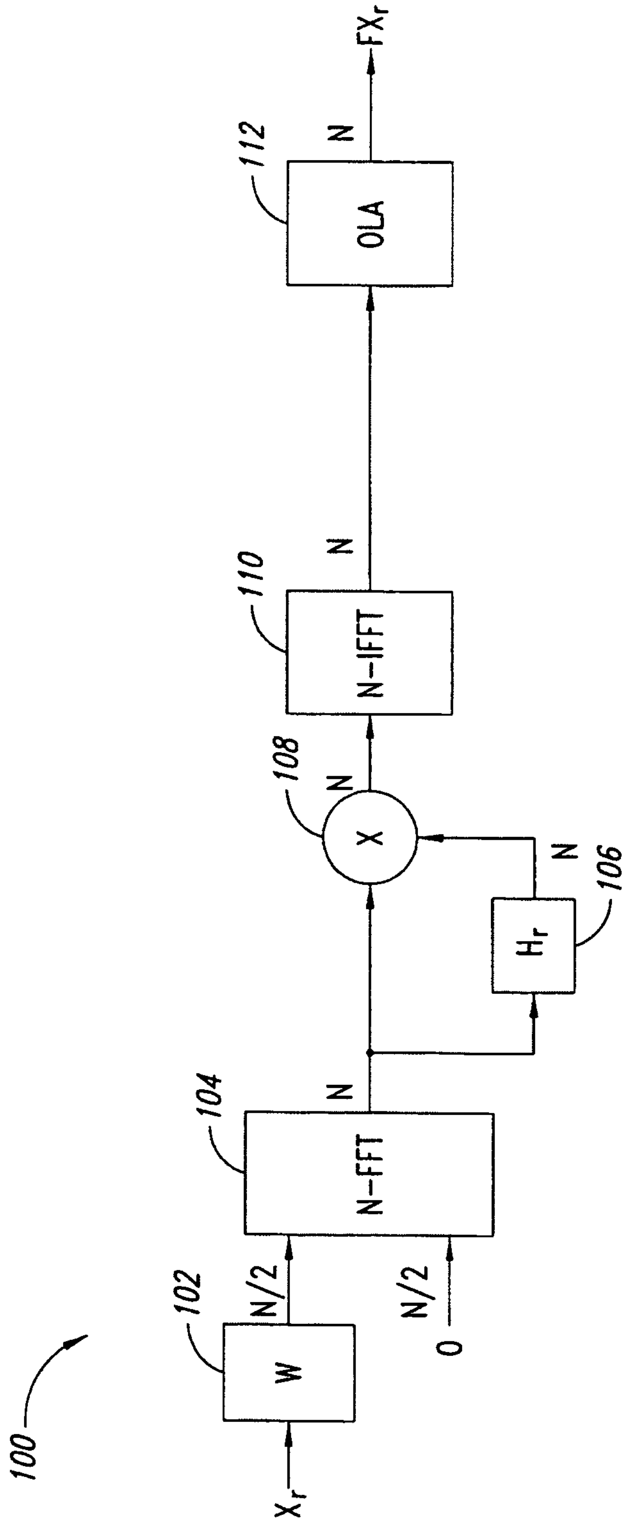
100
$X_r$
W
102
N/2
0
N/2
N-FFT
104
N
$H_r$
106
N
X
108
N
N-IFFT
110
N
OLA
112
N
$FX_r$

FIG. 1

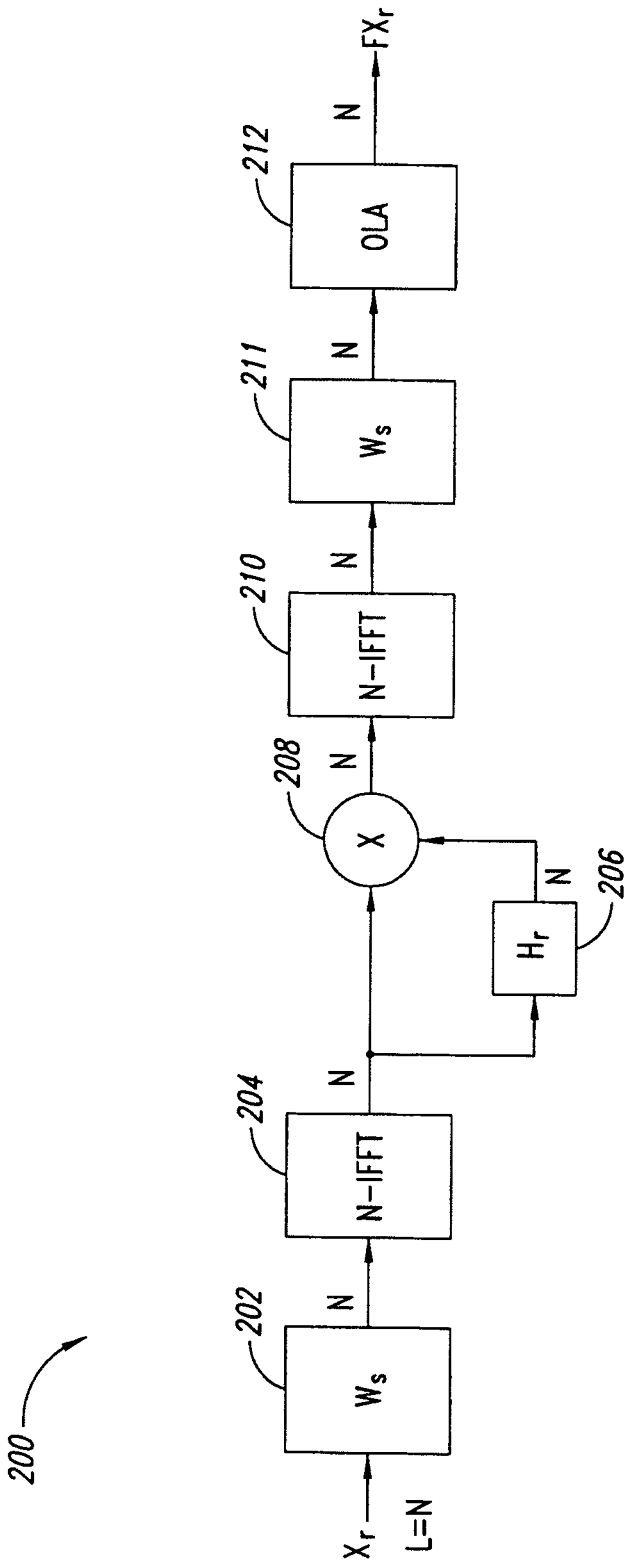
200
$X_r$
L=N
202
$W_s$
N
204
N-IFFT
N
206
$H_r$
N
208
X
N
210
N-IFFT
N
211
$W_s$
N
212
OLA
N
$FX_r$

FIG. 2

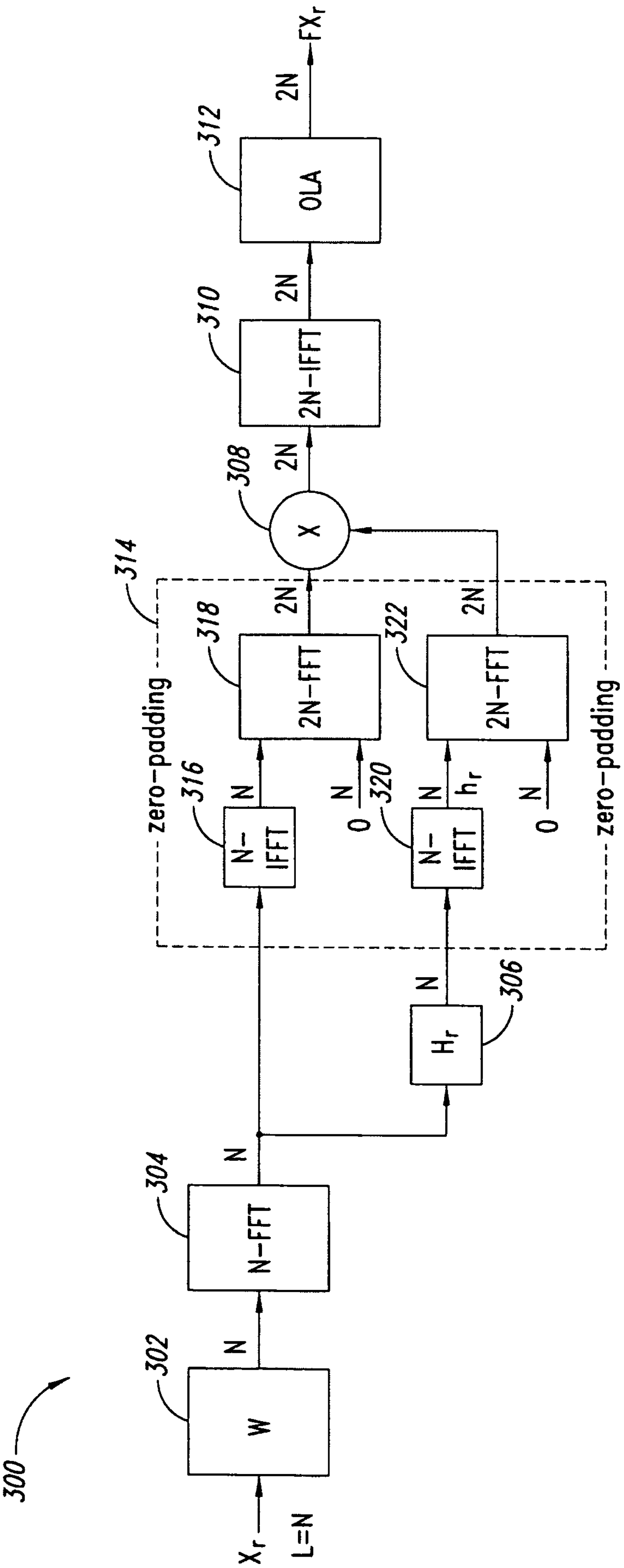
300
$X_r$
L=N
W
302
N
N-FFT
304
N
$H_r$
306
N
zero-padding
314
N-
IFFT
316
N
0
N
318
2N-FFT
2N
N-
IFFT
320
N
$h_r$
0
N
322
2N-FFT
2N
zero-padding
X
308
2N
2N-IFFT
310
2N
OLA
312
2N
$FX_r$

FIG. 3

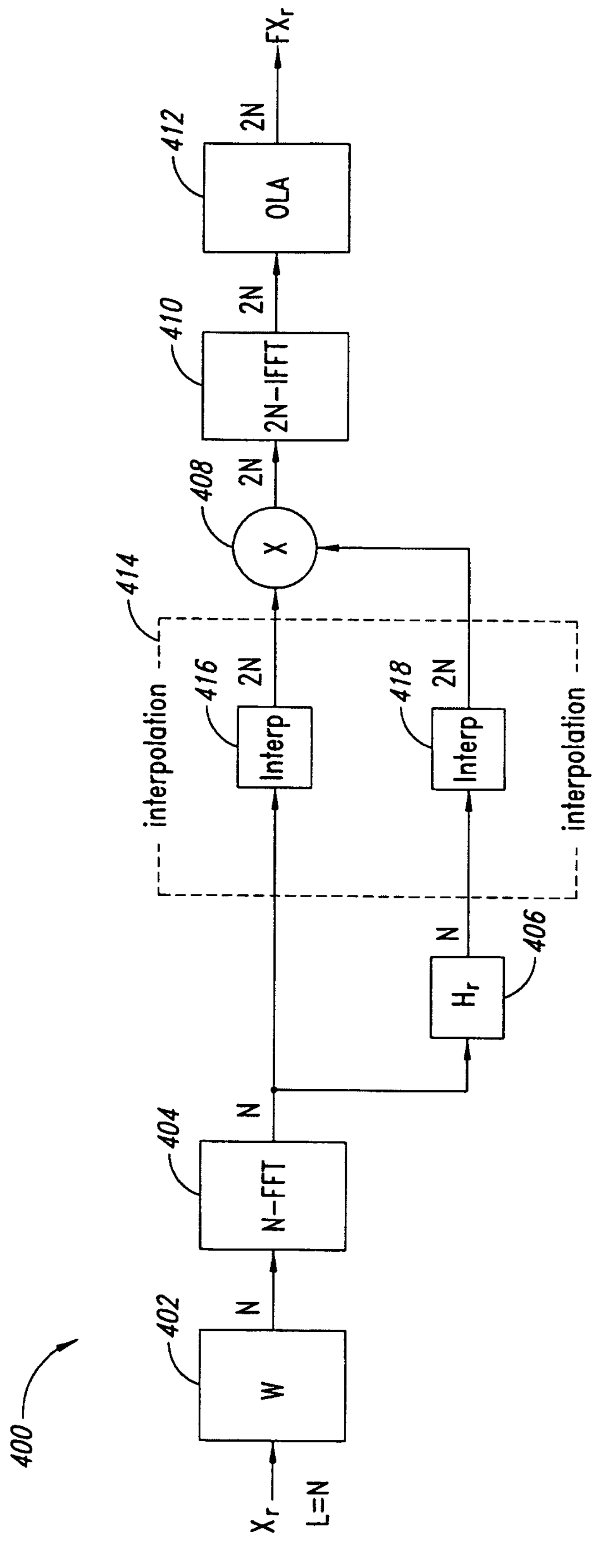
400
402
W
404
N-FFT
406
$H_r$
414
interpolation
416
Interp
418
Interp
408
X
410
2N-IFFT
412
OLA
$X_r$
L=N
N
2N
$FX_r$

FIG. 4

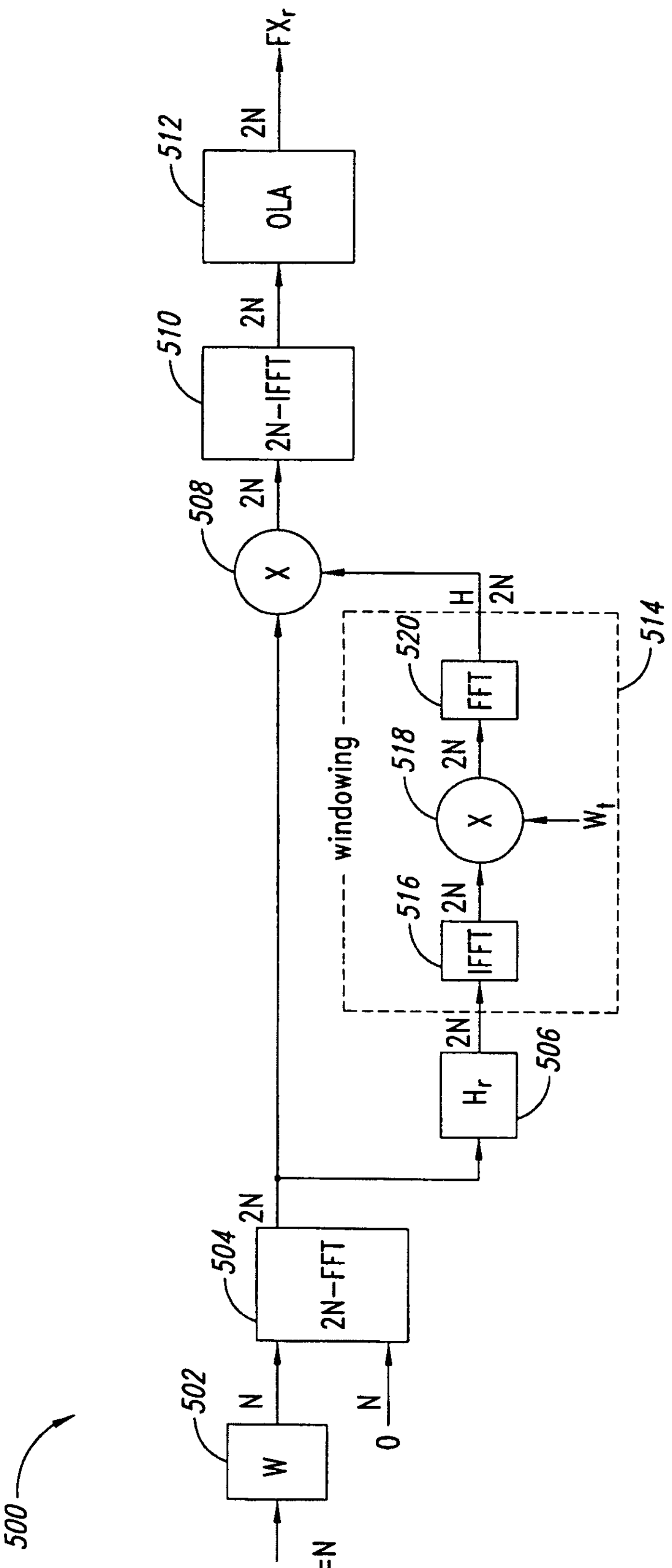
500
502
W
504
2N-FFT
506
$H_r$
508
510
2N-IFFT
512
OLA
514
windowing
516
IFFT
518
520
FFT
$X_r$
L=N
N
0
2N
X
H
$W_t$
$FX_r$

FIG. 5

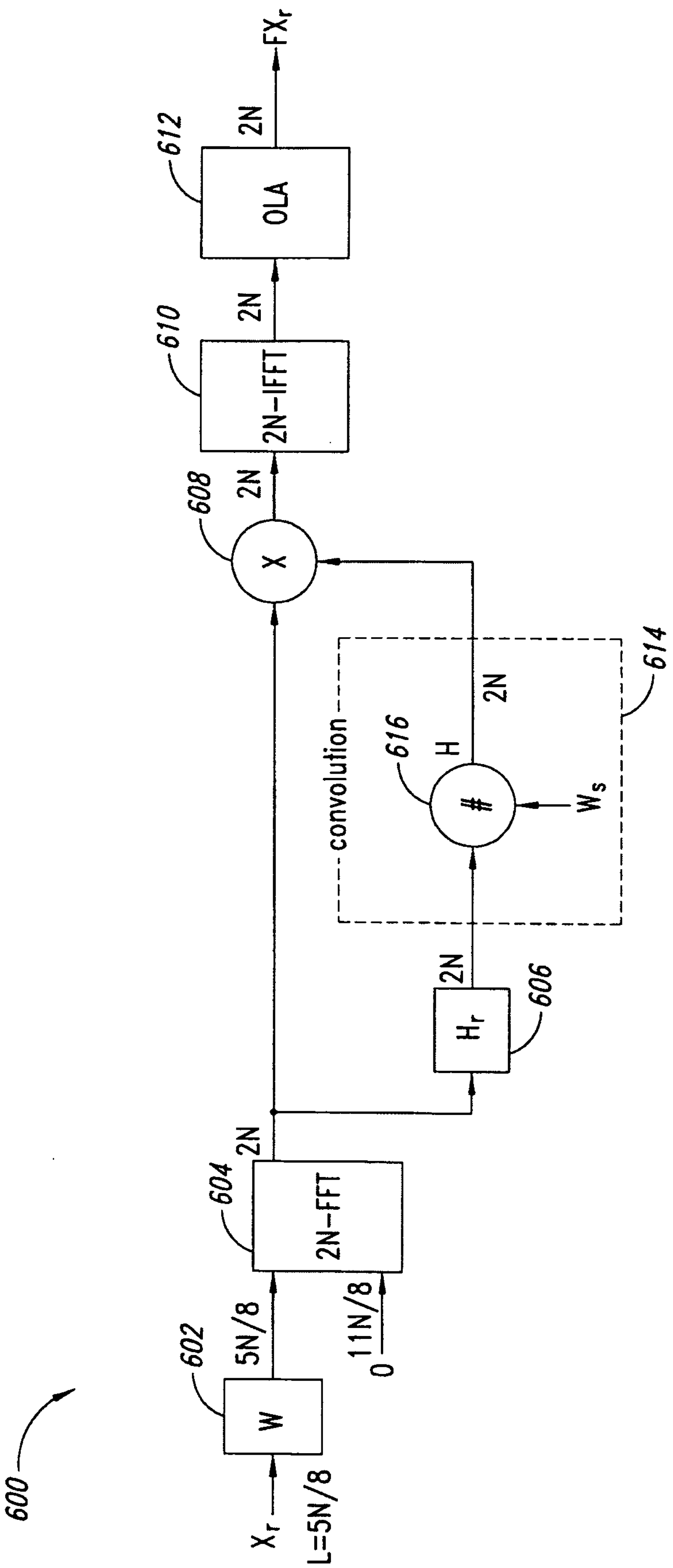
600
Xr
L=5N/8
W
602
5N/8
0
11N/8
2N-FFT
604
2N
Hr
606
2N
convolution
#
616
H
Ws
2N
614
X
608
2N
2N-IFFT
610
2N
OLA
612
2N
FXr

*FIG. 6*

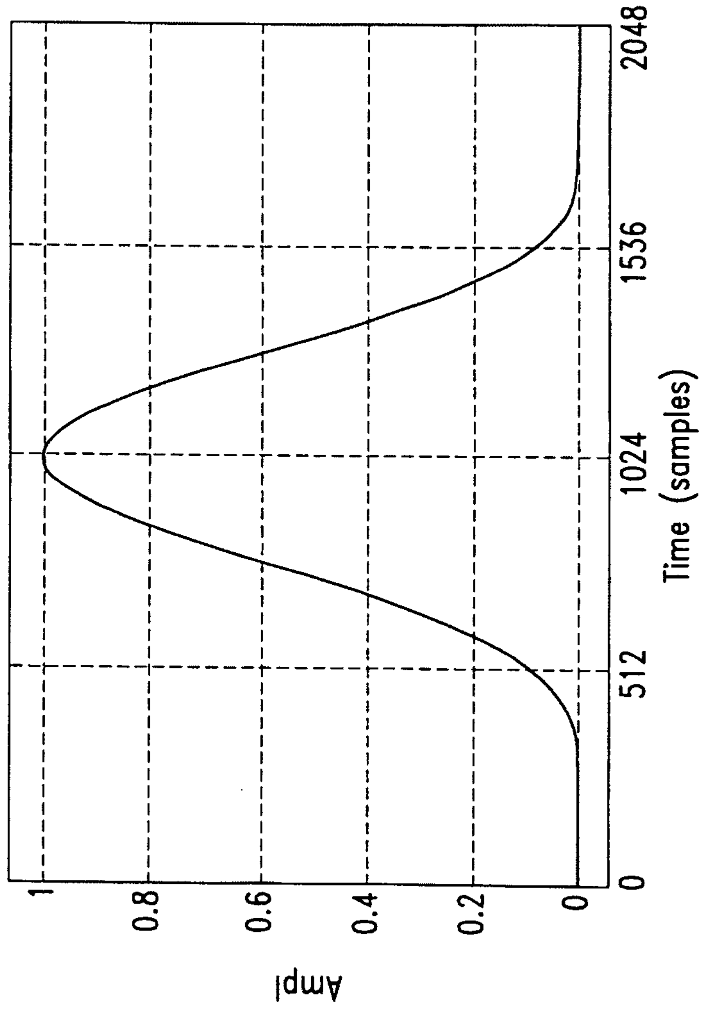


*FIG. 7*

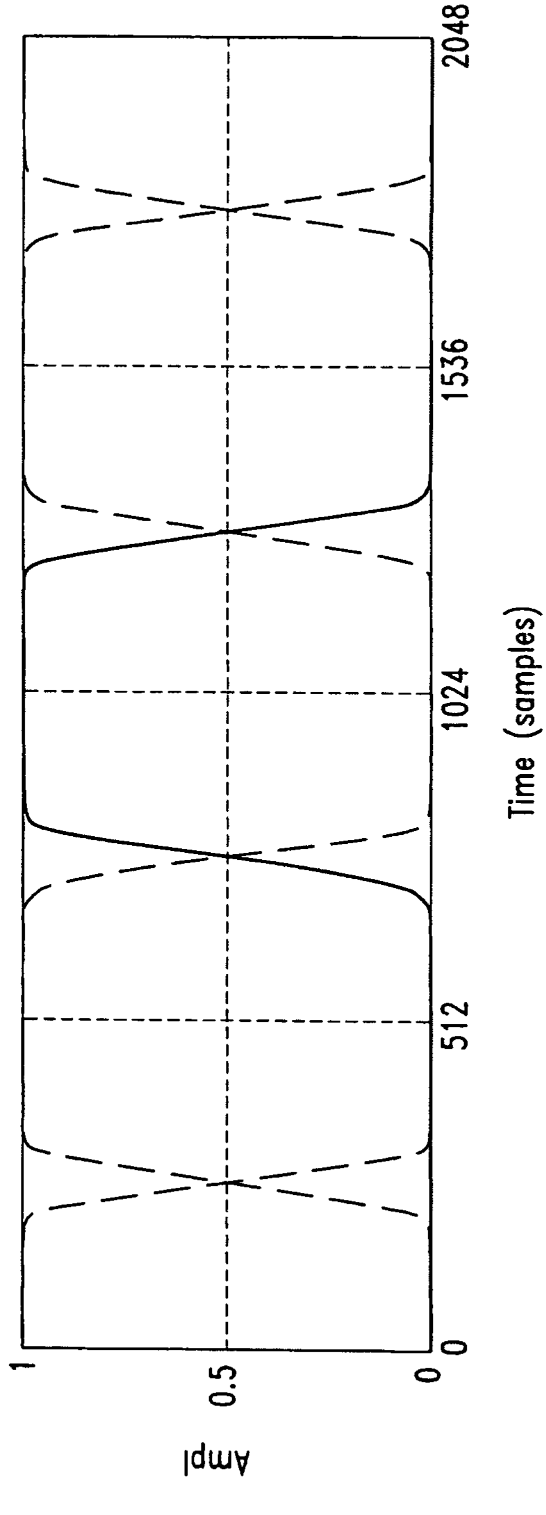


FIG. 8

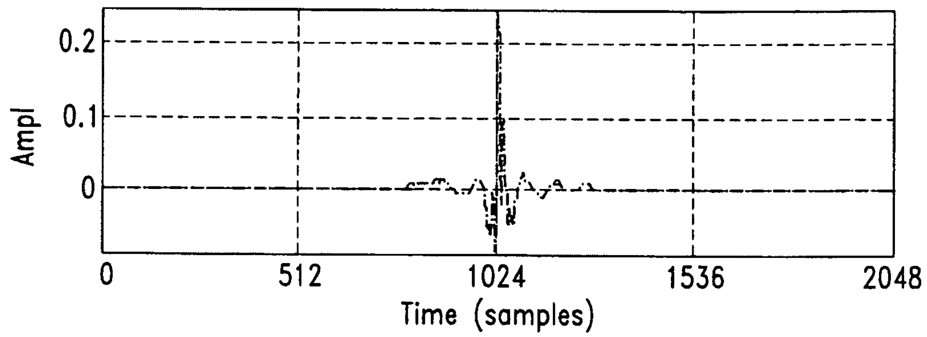


FIG. 9A

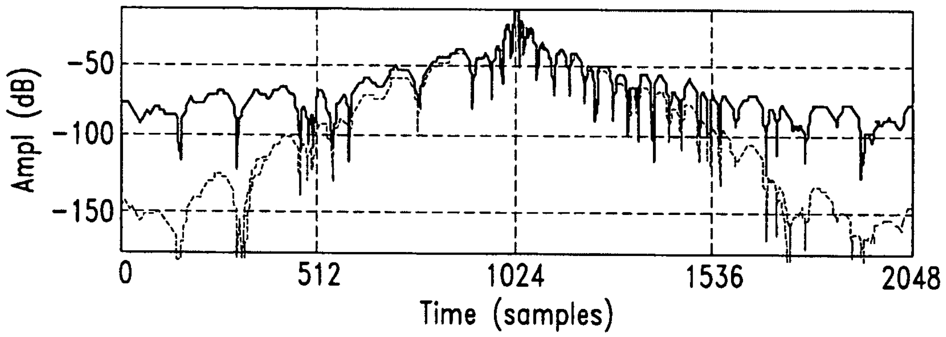


FIG. 9B

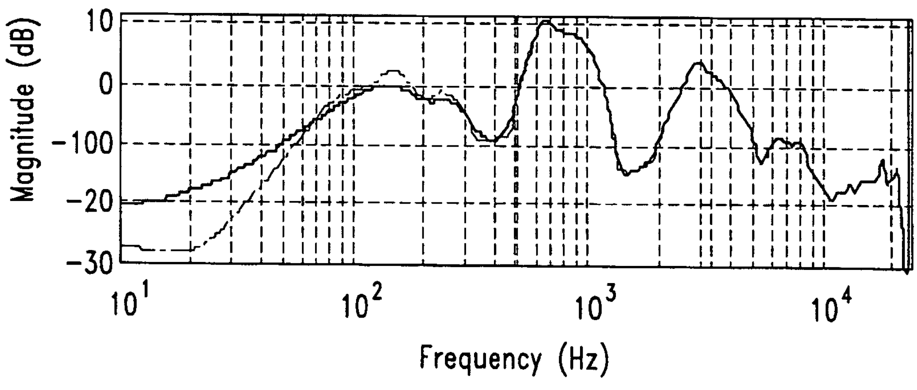


FIG. 9C

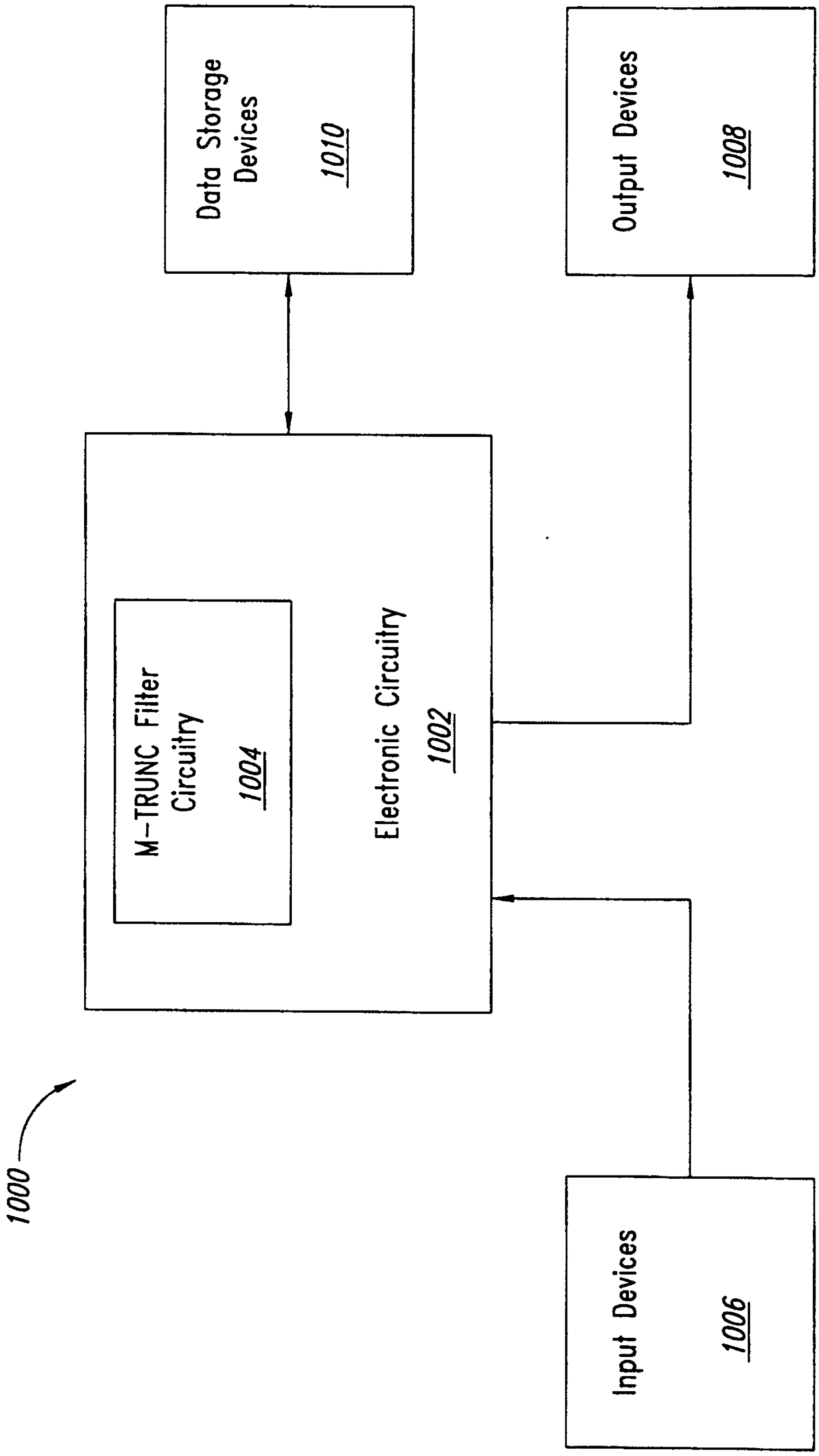
1000
Data Storage Devices
1010
Output Devices
1008
M-TRUNC Filter Circuitry
1004
Electronic Circuitry
1002
Input Devices
1006

FIG. 10